# EUROPEAN PATENT APPLICATION

(11) **EP 4 439 670 A1**
(43) Date of publication of application: **02.10.2024**
(21) Application number: 22898242.7
(22) Date of filing: 05.10.2022
(51) Int. Cl.: H01L 27/146, H01L 23/02

(54) **SOLID-STATE IMAGING DEVICE AND METHOD FOR MANUFACTURING SOLID-STATE IMAGING DEVICE**

(30) Priority: 26.11.2021 JP 2021191861
(71) Applicant: Sony Semiconductor Solutions Corporation, Atsugi-shi, Kanagawa 243-0014 (JP)
(72) Inventor: SHIGETOSHI, Takushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/037345
(87) International publication number: WO 2023/095457

(57) **Abstract**

To improve reliability of a solid-state imaging apparatus.

A solid-state imaging apparatus includes: a chip; and a transparent member. A solid-state image sensor is formed in the chip. The transparent member is directly joined to the chip via a projecting portion. The projecting portion of the transparent member is formed so as to maintain a gap between the transparent member and an imaging region of the solid-state image sensor of the chip. A protective film may be formed on a semiconductor substrate via an anti-reflection film. A color filter or an on-chip lens may be formed for each pixel in the imaging region of the solid-state image sensor of the chip.

## Description

### Technical Field

The present technology relates to a solid-state imaging apparatus and a method of producing the solid-state imaging apparatus. In detail, the present technology relates to packaging of the solid-state imaging apparatus.

### Background Art

From the viewpoint of miniaturization and high reliability, a chip size package in which a light-receiving surface of a solid-state image sensor chip is hermetically sealed and an external connection terminal is drawn out from the back surface has been proposed. For example, as such a chip size package, a configuration in which a sealing member obtained by adhering a frame portion to a flat plate portion is adhered to a front surface of a solid-state image sensor chip has been disclosed (see, for example, Patent Literatures 1 and 2).

### Citation List

### Patent Literature

Patent Literature 1: Japanese Patent Application Laid-open No. 2009-224400
Patent Literature 2: Japanese Patent Application Laid-open No. 2009-267049

### Disclosure of Invention

### Technical Problem

However, an adhesive is used to adhere the sealing member obtained by adhering a frame portion to a flat plate portion to the solid-state image sensor chip. For this reason, the number of joint surfaces between the sealing member and the solid-state image sensor chip increases, which may reduce the reliability of the solid-state imaging apparatus.

The present technology has been made in view of such circumstances, and an object thereof is to improve reliability of a solid-state imaging apparatus.

### Solution to Problem

The present technology has been made to achieve the above-mentioned object, and a first aspect thereof is a solid-state imaging apparatus, including: a chip on which a solid-state image sensor is formed; and
a transparent member that is directly joined to the chip via a projecting portion of the transparent member, the projecting portion maintaining a gap between the transparent member and an imaging region of the solid-state image sensor. This brings about the effect of increasing the joint strength between the chip and the transparent member.

Further, in the first aspect, a joint between the chip and the transparent member may have a single joint interface. This brings about the effect that the transparent member is directly joined to the chip.

Further, in the first aspect,
the transparent member may be directly joined to a peripheral portion of the imaging region via the projecting portion such that a hollow portion is formed on the imaging region. This brings about the effect that the imaging region is sealed while preventing the chip and the transparent member from coming into contact with each other on the imaging region.

Further, in the first aspect, the solid-state image sensor may be a back-illuminated solid-state image sensor. This brings about the effect that the wire is drawn out from the surface of the solid-state image sensor opposite to the imaging region.

Further, in the first aspect, the transparent member may be a glass substrate on which the projecting portion is provided. This brings about the effect that inorganic matters are directly joined to each other.

Further, in the first aspect, a coefficient of thermal expansion of glass of the glass substrate may be within a range of 2.4 to 3.5 ppm/°C. This brings about the effect that the difference in coefficient of thermal expansion between the transparent member and the chip is reduced.

Further, in the first aspect, the chip may include a back-surface wire formed on a surface opposite to a surface on which the imaging region is formed, and a through electrode that penetrates the chip and is connected to the back-surface wire. This brings about the effect that the wire is drawn out from the back surface side of the chip where the imaging region is formed.

Further, in the first aspect, the chip may include a semiconductor substrate on which the imaging region is provided, an anti-reflection film formed on the semiconductor substrate, a protective film formed on the anti-reflection film, a color filter formed on the protective film of the imaging region, and an on-chip lens formed on the color filter of the imaging region, and the transparent member may be directly joined to the protective film of a peripheral portion of the imaging region via the projecting portion. This improves the joint strength by direct joining, and brings about the effect that light reflection caused by the difference in refractive index on the joint surface is suppressed while reducing stress caused by the difference in coefficient of thermal expansion on the joint surface.

Further, in the first aspect, the chip may include a semiconductor substrate on which the imaging region is provided, an anti-reflection film formed on the semiconductor substrate, a protective film formed on the anti-reflection film of the imaging region, a color filter formed on the protective film of the imaging region, and an on-chip lens formed on the color filter of the imaging region, and the transparent member may be directly joined to the antireflection film of a peripheral portion of the imaging region via the projecting portion. This brings about the effect that light reflection caused by the difference in refractive index between the protective film and the transparent member is suppressed while improving the joint strength between the chip and the transparent member.

Further, in the first aspect, the chip may include a semiconductor substrate on which the imaging region is provided, an anti-reflection film formed on the semiconductor substrate of the imaging region, a protective film formed on the anti-reflection film of the imaging region, a color filter formed on the protective film of the imaging region, and an on-chip lens formed on the color filter of the imaging region, and the transparent member may be directly joined to the semiconductor substrate of a peripheral portion of the imaging region via the projecting portion. This brings about the effect that the chip and the transparent member is directly joined to each other without interposing the protective film and the anti-reflection film.

Further, the first aspect may further include an inorganic film that is provided on a front surface of the projecting portion and is formed of a material different from that of the transparent member. This brings about the effect of optimizing the joint strength, the difference in coefficient of thermal expansion, and the difference in refractive index between the chip and the transparent member.

Further, in the first aspect, the material of the inorganic film may be SiN, SiCN, or SiO₂. This brings about the effect of optimizing the material to be used for direct joining between the chip and the transparent member.

Further, in the first aspect, a bottom surface of a recessed portion surrounded by the projecting portion may have a curvature or a pattern having an optical function. This brings about the effect that the transparent member has a light collection function.

Further, the first aspect may further include an antireflection film formed on a surface of the transparent member other than a light incident path to the imaging region. This brings about the effect that the transparent member has a light collection function, which suppresses stray light and a decrease in sensitivity due to reflection of light that has entered the transparent member.

Further, in the first aspect, a side surface of a recessed portion surrounded by the projecting portion may have a structure that scatters incident light. This brings about the effect reducing flare due to stray light.

Further, in the first aspect, the transparent member may include a step that is located on an outer side surface of the projecting portion to separate a tip of the projecting portion from an end portion of the chip. This brings about the effect of suppressing the occurrence of cracks and chipping in the vicinity of the joint surface between the chip and the transparent member when performing separation into pieces by blade dicing.

Further, the first aspect may further include at least one of a first groove provided along an outer periphery of the chip or a second groove that connects the hollow portion to an outside of the transparent member on at least one of a joint surface on a side of the projecting portion or a joint surface on a side of the chip. This brings about the effect that chipping or cracks that have occurred at the end portion of the chip are stopped at the position of the first groove before reaching the imaging region or the gas released from the solid-state image sensor is escaped to the outside via the second groove.

Further, in the first aspect, the second groove may have a width of less than 5 µm and a depth of less than 1 µm. This brings about the effect of preventing moisture from entering during a cleaning step or the like while allowing the released gas to escape via the second groove.

Further, a second aspect is a method of producing a solid-state imaging apparatus, including:
a step of forming a projecting portion on a transparent member; and
a step of directly joining the transparent member to a chip on which a solid-state image sensor is formed such that a gap between the transparent member and an imaging region of the solid-state image sensor is maintained via the projecting portion. This brings about the effect of increasing the joint strength between the chip and the transparent member.

Further, in the second aspect, the step of directly joining may include a step of activating at least one of a joint surface on a side of the chip or a joint surface on a side of the transparent member, and a step of crimping the joint surface on the side of the chip and the joint surface on the side of the transparent member at a temperature of 250°C or less. This brings about the effect of increasing the joint strength between the chip and the transparent member while suppressing damage to the chip.

### Brief Description of Drawings

[Fig. 1] Fig. 1 is a diagram showing a configuration example of a solid-state imaging apparatus according to a first embodiment.
[Fig. 2] Fig. 2 is a first cross-sectional view showing an example of a method of producing the solid-state imaging apparatus according to the first embodiment.
[Fig. 3] Fig. 3 is a second cross-sectional view showing an example of the method of producing the solid-state imaging apparatus according to the first embodiment.
[Fig. 4] Fig. 4 is a diagram showing a configuration example of a solid-state imaging apparatus according to a second embodiment.
[Fig. 5] Fig. 5 is a diagram showing a configuration example of a solid-state imaging apparatus according to a third embodiment.
[Fig. 6] Fig. 6 is a cross-sectional view showing a configuration example of a solid-state imaging apparatus according to a fourth embodiment.
[Fig. 7] Fig. 7 is a cross-sectional view showing a configuration example of a solid-state imaging apparatus according to a fifth embodiment.
[Fig. 8] Fig. 8 is a cross-sectional view showing a configuration example of a solid-state imaging apparatus according to a sixth embodiment.
[Fig. 9] Fig. 9 is a cross-sectional view showing a configuration example of a solid-state imaging apparatus according to a seventh embodiment.
[Fig. 10] Fig. 10 is a diagram showing a configuration example of a solid-state imaging apparatus according to an eighth embodiment.
[Fig. 11] Fig. 11 is a diagram showing a configuration example of a solid-state imaging apparatus according to a ninth embodiment.
[Fig. 12] Fig. 12 is a diagram showing a configuration example of the solid-state imaging apparatus according to the ninth embodiment before being separated into pieces.
[Fig. 13] Fig. 13 is a diagram showing a configuration example of a solid-state imaging apparatus according to a tenth embodiment.
[Fig. 14] Fig. 14 is a diagram showing a configuration example of a solid-state imaging apparatus according to an eleventh embodiment.
[Fig. 15] Fig. 15 is a diagram showing a configuration example of a solid-state imaging apparatus according to a twelfth embodiment.
[Fig. 16] Fig. 16 is a diagram showing a configuration example of a solid-state imaging apparatus according to a thirteenth embodiment.

### Mode(s) for Carrying Out the Invention

Embodiments for carrying out the present technology (hereinafter, referred to as embodiments) will be described below. Description will be made in the following order.
1. First embodiment (example in which a transparent member is directly joined to a protective film of a chip)
2. Second embodiment (example in which a transparent member is directly joined to an anti-reflection film of a chip)
3. Third embodiment (example in which a transparent member is directly joined to a semiconductor substrate of a chip)
4. Fourth embodiment (example in which a transparent member and a chip are directly joined to each other via an inorganic film)
5. Fifth embodiment (example in which a curvature is provided on a bottom surface of a recessed portion of a transparent member)
6. Sixth embodiment (example in which an anti-reflection film is provided on a front surface of a transparent member)
7. Seventh embodiment (example in which a moth-eye structure is provided on a side surface of a recessed portion of a transparent member)
8. Eighth embodiment (example in which a zigzag shape is provided on a side surface of a recessed portion of a transparent member)
9. Ninth embodiment (example in which a step is provided on an outer side surface of a projecting portion of a transparent member)
10. Tenth embodiment (example in which a groove for stopping cracks is provided in a transparent member and a chip)
11. Eleventh embodiment (example in which a straight groove for exhausting released gas is provided in a chip)
12. Twelfth embodiment (example in which a zigzag groove for exhausting released gas is provided in a chip)
13. Thirteenth embodiment (example in which a groove for stopping cracks and a groove for exhausting released gas are provided in a chip)

### <1. First embodiment>

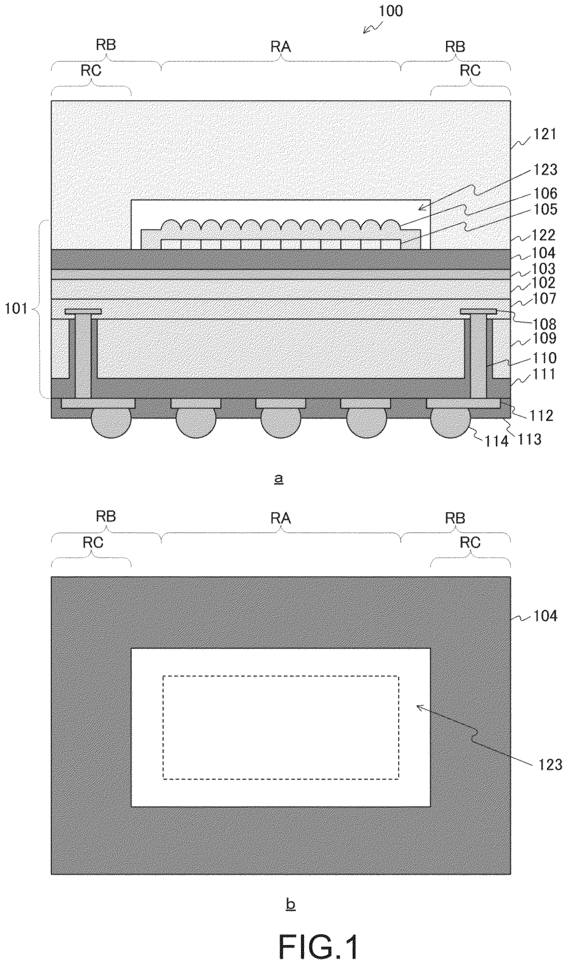

Fig. 1 is a diagram showing a configuration example of a solid-state imaging apparatus according to a first embodiment. Note that Part a in the figure is a cross-sectional view showing a configuration example of a solid-state imaging apparatus 100, and Part b in the figure is a plan view showing a configuration example of a joint region RC of a protective film 104.

In Fig. 1, the solid-state imaging apparatus 100 includes a solid-state image sensor chip 101 and a transparent member 121.

A solid-state image sensor is formed in the solid-state image sensor chip 101. The solid-state image sensor is, for example, a back-illuminated solid-state image sensor. The solid-state image sensor may be a CMOS (Complementary Metal Oxide Semiconductor) image sensor or a CCD (Charge Coupled Device) image sensor.

The solid-state image sensor chip 101 includes a semiconductor substrate 102 in which an imaging region RA and a non-imaging region RB are provided. The semiconductor substrate 102 is, for example, a single crystal silicon substrate. The semiconductor substrate 102 may be a group III-V substrate such as GaAs. In the imaging region RA, pixels and pixel transistors are arranged in a matrix along the row direction and the column direction. In the non-imaging region RB, peripheral circuits that drive the pixel transistors and output signals read from the pixels are provided.

For example, in a back-illuminated solid-state image sensor, the imaging region RA is provided on the back surface side of the semiconductor substrate 102. On the back surface side of the semiconductor substrate 102, an anti-reflection film 103 is formed on the semiconductor substrate 102. As the material of the antireflection film 103, for example, hafnium oxide (HfO₂), an aluminum oxide (Al₂O₃) film, a zirconium oxide (ZrO₂) film, a tantalum oxide (Ta₂O₅) film, a titanium oxide (TiO₂) film, a lanthanum oxide (La₂O₃) film, a praseodymium oxide (Pr₂O₃) film, a cerium oxide (CeO₂) film, a neodymium oxide (Nd₂O₃) film, a promethium oxide (Pm₂O₃) film, a samarium oxide (Sm₂O₃) film, an europium oxide (Eu₂O₃) film, a gadolinium oxide (Gd₂O₃) film, a terbium oxide(Tb₂O₃) film, a dysprosium oxide (Dy₂O₃) film, a holmium oxide (Ho₂O₃) film, a thulium oxide (Tm₂O₃) film, an ytterbium oxide (Yb₂O₃) film, a lutetium oxide (Lu₂O₃) film, an yttrium oxide (Y₂O₃)film, a hafnium nitride film, an aluminum nitride film, a hafnium oxynitride film, or an aluminum oxynitride film can be used. The deposition method of forming these films may be a CVD (Chemical Vapor Deposition) method, a PVD (Physical Vapor Deposition) method, or an ALD (Atomic Layer Deposition) method.

On the back surface side of the semiconductor substrate 102, the protective film 104 is formed on the anti-reflection film 103. As the material of the protective film 104, for example, an inorganic matter such as SiO₂ and SiN can be used.

A color filter 105 is formed on the protective film 104 for each pixel. The color filters 105 can form, for example, a Bayer array. As the material of the color filter 105, for example, a transparent resin to which a coloring agent is added can be used. On the color filter 105, an on-chip lens 106 is formed for each pixel. As the material of the on-chip lens 106, for example, a transparent resin such as acrylic and polycarbonate can be used.

On the front surface side of the semiconductor substrate 102, a wiring layer 107 is formed on the semiconductor substrate 102. A wire embedded in an insulation layer is provided in the wiring layer 107. A land electrode 108 to which a through electrode 110 is connected can be formed in the wiring layer 107. As the material of the insulation layer, for example, SiO₂ can be used. As the materials of the wire and the land electrode 108, for example, a metal such as Al and Cu can be used.

A support substrate 109 is attached onto the wiring layer 107. As the material of the support substrate 109, for example, Si or glass can be used. The thickness of the support substrate 109 can be made larger than that of the semiconductor substrate 102. The through electrode 110 is embedded in the support substrate 109 via a back-surface insulation film 111. The through electrode 110 penetrates the support substrate 109 in the thickness direction and is connected to the land electrode 108. Further, on the back surface side of the support substrate 109, a back-surface wire 112 is formed via the back-surface insulation film 111. A back-surface protective film 113 is formed on the back-surface wire 112. As the materials of the through electrode 110 and the back-surface wire 112, for example, a metal such as Cu, Ti, Ta, Al, W, Ni, Ru, and Co can be used, and a stacked structure of a plurality of materials may be used. As the material of the back-surface insulation film 111, for example, SiO₂, SiON, SiN, SiOC, or SiCN can be used when it is an inorganic film. When it is an organic film, a resin having a skeleton of silicone, polyimide, acrylic, epoxy, or the like can be used. As the material of the back-surface protective film 113, for example, a solder resist can be used.

A protruding electrode 114 is connected to the back-surface wire 112. At this time, the back-surface protective film 113 is removed at the connection position between the back-surface wire 112 and the protruding electrode 114, and the back-surface wire 112 is exposed from the back-surface protective film 113. The protruding electrode 114 can be used as an external connection terminal for connecting the solid-state image sensor chip 101 to a motherboard or the like. The protruding electrode 114 may be, for example, a ball electrode such as a solder ball, or a pillar electrode formed of a conductor.

The transparent member 121 includes a projecting portion 122. The projecting portion 122 can be formed along the periphery of the transparent member 121. The projecting portion 122 is integrated with the transparent member 121. Here, the transparent member 121 and the projecting portion 122 can be integrally formed of the same material. For example, the transparent member 121 on which the projecting portion 122 is provided can be formed on the basis of processing of a base material including a single material. At this time, there is no interface between the transparent member 121 and the projecting portion 122. The shape of the side surface of the projecting portion 122 may be vertical or may have a slight taper angle. As the material of the transparent member 121, for example, an inorganic matter such as glass and quartz can be used. As the transparent member 121, a transparent substrate on which the projecting portion 122 is provided may be used. In the case where a glass substrate is used as the transparent member 121, it is favorable to set the coefficient of thermal expansion (CTE) of glass of the glass substrate to be within the range of 2.4 to 3.5 ppm/°C. It is favorable to set the refractive index of the transparent member 121 to be substantially equal to the refractive index of the protective film 104. For example, in the case where the material of the protective film 104 is SiO₂, it is favorable to set the refractive index of the transparent member 121 to approximately 1.5. In the case where the material of the protective film 104 is SiN, it is favorable to set the refractive index of the transparent member 121 to approximately 2. An antireflection structure, a wafer-level lens, or the like may be stacked on the transparent member 121.

The transparent member 121 is directly joined to the solid-state image sensor chip 101 via the projecting portion 122. Here, the transparent member 121 is directly joined to a peripheral portion of the imaging region RA via the projecting portion 122 such that a hollow portion 123 is formed on the imaging region RA. At this time, the projecting portion 122 is formed such that a gap between the imaging region RA of the solid-state image sensor and the transparent member 121 is maintained. It is favorable to set the height of the projecting portion of the transparent member 121 to be within the range of 2 to 30 µm. The direct joining may be a method of pressurejoining at a temperature of 250°C or less while the plasma activation of the joint surface is performed.

For example, in plasma activation using glass for the transparent member 121, oxygen plasma or nitrogen plasma can be applied to the joint surface to perform hydrophilic treatment on the joint surface. Then, the joint surfaces can be in close contact with each other on the basis of the hydrogen bonds between OH groups formed on the joint surfaces due to the adsorption of moisture in the air. Then, the OH groups are decomposed by heat treatment, the hydrogens generated at that time are diffused into the interface layer, and thus, the direct joining based on the Si-O-Si bond via oxygen can be realized. Here, by performing plasma activation of the joint surface before heat treatment, it is possible to improve the adsorption of moisture on the joint surface and achieve the joint strength necessary for ensuring reliability of the solid-state imaging apparatus 100 even with heat treatment of a temperature of 250°C or less.

In order to directly join the projecting portion 122 to the peripheral portion of the imaging region RA, the joint region RC is provided in the non-imaging region RB of the solid-state image sensor chip 101. Further, in the joint region RC, the color filter 105 and the on-chip lens 106 are not disposed and the protective film 104 is exposed. Then, by crimping the tip of the projecting portion 122 to the protective film 104 of the joint region RC, it is possible to directly join the transparent member 121 to the solid-state image sensor chip 101 while forming the hollow portion 123 on the imaging region RA. At this time, a single joint interface is formed between the solid-state image sensor chip 101 and the transparent member 121.

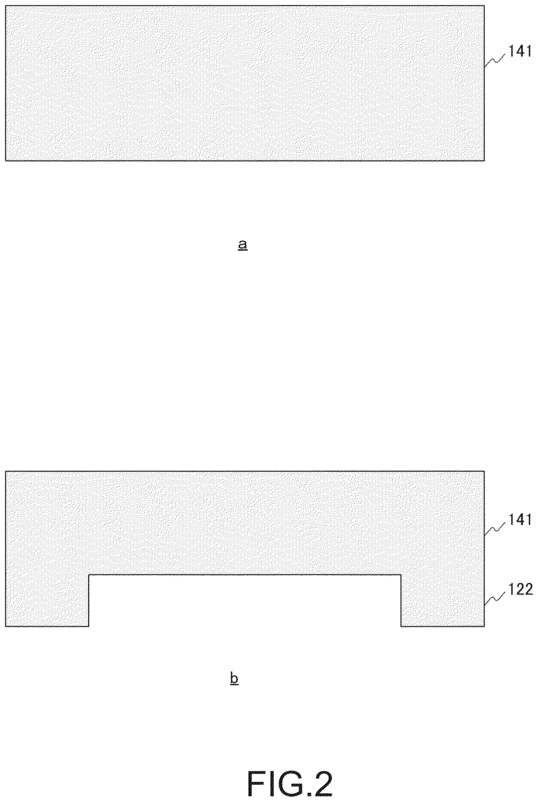

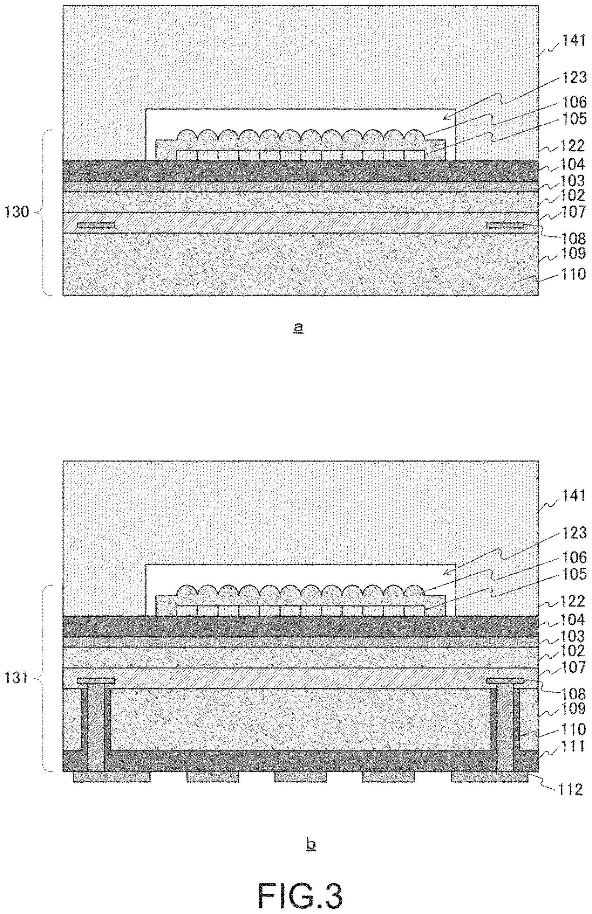

Fig. 2 and Fig. 3 are each a cross-sectional view showing an example of a method of producing the solid-state imaging apparatus according to the first embodiment.

As shown in Part a of Fig. 2, a transparent substrate wafer 141 is prepared. The thickness of the transparent substrate wafer 141 can be set to, for example, approximately 50 to 1000 µm. A protective film or the like may be formed on the back surface side of the transparent substrate wafer 141. In the case where a protective film is formed on the back surface side of the transparent substrate wafer, it can be removed in the final step.

Next, as shown in Part b of Fig. 2, the front surface side of the transparent substrate wafer 141 is processed by lithography and dry etching to form the projecting portion 122 on the front surface side of the transparent substrate wafer 141. The dry etching may be, for example, plasma etching or RIE (Reactive Ion Etching). In the case where the optical characteristics of the transparent substrate wafer 141 change due to damage to the dry-etched front surface, the damaged layer may be removed by wet etching or the like.

Here, the projecting portion 122 is formed on the transparent substrate wafer 141 on the basis of processing of the transparent substrate wafer 141. This eliminates the necessity to adhere the projecting portion 122 to the transparent member 121 in order to provide the projecting portion 122 on the transparent member 121 shown in Fig. 1, and makes it possible to form the transparent member 121 and the projecting portion 122 using the same material. Therefore, it is possible to suppress the complication of the step of producing the transparent member 121 on which the projecting portion 122 is provided and suppress a decrease in reliability due to thermal stress.

Next, as shown in Part a of Fig. 3, the solid-state image sensor wafer 130 is prepared. Note that the solid-state image sensor wafer 130 is a wafer before forming the through electrode 110 and the back-surface wire 112 shown in Fig. 1. Then, at least one of the front surface of the projecting portion 122 of the transparent substrate wafer 141 or the front surface of the protective film 104 of the solid-state image sensor wafer 130 is activated by plasma treatment. Then, by crimping the front surface of the projecting portion 122 of the transparent substrate wafer 141 and the front surface of the protective film 104 of the solid-state image sensor wafer 130 at a temperature of 250°C or less, the transparent substrate wafer 141 and the solid-state image sensor wafer 130 are directly joined to each other. At this time, the coefficient of thermal expansion of the transparent substrate wafer 141 and the coefficient of thermal expansion of the protective film 104 may be caused to match. As a result, it is possible to reduce the thermal stress remaining when the transparent substrate wafer 141 and the solid-state image sensor wafer 130 are cooled. Further, by setting the crimping temperature of the direct joining to 250°C or less, it is possible to suppress the damage to the color filter 105. Note that in the case where the time taken by crimping of the direct joining is short, the damage to the color filter 105 is small even if the crimping temperature of the direct joining exceeds 200°C. For this reason, the crimping temperature of the direct joining only needs to be 250°C or less.

Next, as shown in Part b of Fig. 3, a solid-state image sensor wafer 131 in which the through electrode 110 and the back-surface wire 112 are provided is formed on the back surface side of the solid-state image sensor wafer 130. Note that although a via-last process is taken in Part b of Fig. 3, a via-middle process may be used.

Next, as shown in Fig. 1, the back-surface protective film 113 and the protruding electrode 114 are formed on the back surface side of the solid-state image sensor wafer 131. Then, by separating the solid-state image sensor wafer 131 to which the transparent substrate wafer 141 is directly joined into chips by a method such as dicing, the solid-state imaging apparatus 100 in which the transparent member 121 is directly joined to the solid-state image sensor chip 101 is formed.

As described above, in accordance with the above-mentioned first embodiment, by directly joining the solid-state image sensor chip 101 and the transparent member 121 to each other, there is no need to use an adhesive in order to join the solid-state image sensor chip 101 and the transparent member 121 to each other. Therefore, it is possible to prevent the joint strength from decreasing due to an adhesive, suppress light reflection caused by the difference in refractive index on the joint surface while reducing stress caused by the difference in coefficient of thermal expansion on the joint surface, and improve the reliability of the solid-state imaging apparatus 100.

Further, in the direct joining between the solid-state image sensor chip 101 and the transparent member 121, a single joint interface is formed between the solid-state image sensor chip 101 and the transparent member 121. For this reason, it is possible to reduce the number of joint interfaces between the solid-state image sensor chip 101 and the transparent member 121 as compared with the case where an adhesive is used in order to join the solid-state image sensor chip 101 and the transparent member 121 to each other. As a result, it is possible to suppress peeling between the solid-state image sensor chip 101 and the transparent member 121 via the joint interface, improve the yield of the solid-state imaging apparatus 100, and improve the reliability.

Further, by directly joining the transparent member 121 to the joint region RC of a peripheral portion of the imaging region RB via the projecting portion 122, the hollow portion 123 can be formed on the imaging region RA. Therefore, it is possible to seal the imaging region RA while preventing the solid-state image sensor chip 101 and the transparent member 121 from coming into contact with each other on the imaging region RA, and improve the reliability without deteriorating the optical performance of the solid-state imaging apparatus 100.

Further, a back-illuminated solid-state image sensor is used as a solid-state image sensor. As a result, it is possible to improve the light-receiving area of the solid-state image sensor, and achieve miniaturization and higher resolution of the solid-state imaging apparatus 100 while suppressing a decrease in sensitivity of the solid-state image sensor.

Further, by using, as the transparent member 121, a glass substrate on which the projecting portion 122 is provided, it is possible to directly join the inorganic matters to each other. Therefore, it is possible to improve the joint strength between the solid-state image sensor chip 101 and the transparent member 121, and suppress light reflection caused by the difference in refractive index on the joint surface while reducing stress caused by the difference in coefficient of thermal expansion on the joint surface. As a result, it is possible to improve the reliability of the solid-state imaging apparatus 100 while dealing with a decrease in joining area due to the miniaturization of the solid-state imaging apparatus 100, and directly join the solid-state image sensor chip 101 and the transparent member 121 to each other while suppressing an increase in the number of steps.

Further, setting the coefficient of thermal expansion of the glass substrate used for the transparent member 121 to be within the range of 2.4 to 3.5 ppm/°C, it is possible to reduce the difference in coefficient of thermal expansion between the solid-state image sensor chip 101 and the transparent member 121. Therefore, it is possible to reduce the stress caused by the difference in coefficient of thermal expansion between the solid-state image sensor chip 101 and the transparent member 121, and suppress warping of the solid-state image sensor chip 101.

Further, the transparent member 121 is directly joined to the protective film 104 of the joint region RC via the projecting portion 122 while the color filter 105 and the on-chip lens 106 of the peripheral portion of the imaging region RA are not disposed. As a result, it is possible to form the joint members using the same material. Therefore, it is possible to improve the joint strength by direct joining, and prevent light reflection caused by the difference in refractive index on the joint surface without generating stress caused by the difference in coefficient of thermal expansion on the joint surface. As a result, it is possible to improve the reliability of the solid-state imaging apparatus 100 while dealing with a decrease in joining area due to the miniaturization of the solid-state imaging apparatus 100, and directly join the solid-state image sensor chip 101 and the transparent member 121 to each other while suppressing an increase in the number of steps.

Further, the back-surface wire 112 is provided on the back surface side of the solid-state image sensor chip 101, and the through electrode 110 that penetrates the solid-state image sensor chip 101 is provided. This eliminates the necessity to draw out the wire from the front surface side of the solid-state image sensor chip 101 in which the imaging region RA is formed, and makes it possible to increase the exclusive area of the imaging region RA on the front surface side of the solid-state image sensor chip 101.

Further, the transparent substrate wafer 141 is directly joined to the solid-state image sensor wafer 130, and then separated into chips by a method such as dicing. As a result, it is possible to directly join the transparent member 121 to each of the plurality of solid-state image sensor chips 101 all at once. This eliminates the necessity to individually join the transparent member 121 to the solid-state image sensor chip 101 and make the production step more efficient.

Note that in the above-mentioned first embodiment, a method of forming the projecting portion 122 of the transparent substrate wafer 141 on the basis of processing of the front surface side of the transparent substrate wafer 141 has been described. In addition to this method, the transparent substrate wafer 141 including the projecting portion 122 may be formed on the basis of a glass mold.

### <2. Second embodiment>

Although the transparent member 121 is directly joined to the protective film 104 of the solid-state image sensor chip 101 in the above-mentioned first embodiment, the transparent member 121 is directly joined to the anti-reflection film 103 in this second embodiment.

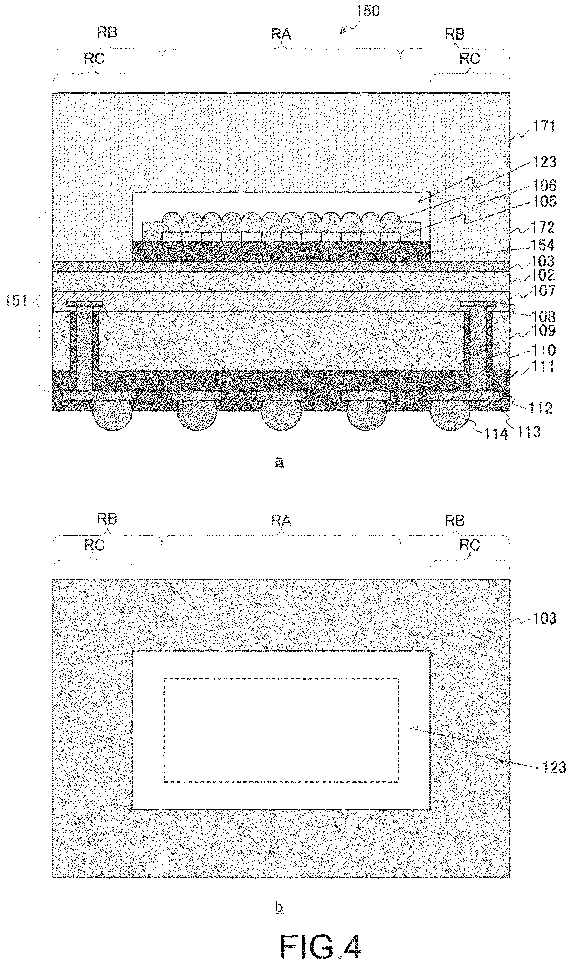

Fig. 4 is a diagram showing a configuration example of a solid-state imaging apparatus according to the second embodiment. Note that Part a of Fig. 4 is a cross-sectional view showing a configuration example of a solid-state imaging apparatus 150, and Part b of Fig. 4 is a plan view showing a configuration example of the joint region RC of the anti-reflection film 103.

In the solid-state imaging apparatus 150 shown in Fig. 4, a solid-state image sensor chip 151 and a transparent member 171 are provided instead of the solid-state image sensor chip 101 and the transparent member 121 in the above-mentioned first embodiment.

In the solid-state image sensor chip 151, a protective film 154 is provided instead of the protective film 104 in the above-mentioned first embodiment. The other configurations of the solid-state image sensor chip 151 are the same as the configurations of the solid-state image sensor chip 101 in the above-mentioned first embodiment. In the joint region RC of the peripheral portion of the imaging region RA, the protective film 154 is not disposed and the anti-reflection film 103 is exposed from the protective film 154. The other configurations of the protective film 154 are the same as the configurations of the protective film 104 in the above-mentioned first embodiment. In the transparent member 171, a projecting portion 172 is provided instead of the projecting portion 122 in the above-mentioned first embodiment. The other configurations of the transparent member 171 are the same as the configurations of the transparent member 121 in the above-mentioned first embodiment.

The transparent member 171 is directly joined to the solid-state image sensor chip 151 via the projecting portion 172. At this time, the tip of the projecting portion 172 is directly joined to the anti-reflection film 103 of the joint region RC.

As described above, in accordance with the above-mentioned second embodiment, the transparent member 171 is directly joined to the anti-reflection film 103 exposed from the protective film 154. As a result, it is possible to suppress light reflection caused by the difference in refractive index between the protective film 15 and the transparent member 171 while improving the joint strength between the solid-state image sensor chip 151 and the transparent member 171, as compared with the case of using an adhesive.

### <3. Third embodiment>

Although the transparent member 121 has been directly joined to the protective film 104 of the solid-state image sensor chip 101 in the above-mentioned first embodiment, the transparent member 121 is directly joined to the semiconductor substrate 102 in this third embodiment.

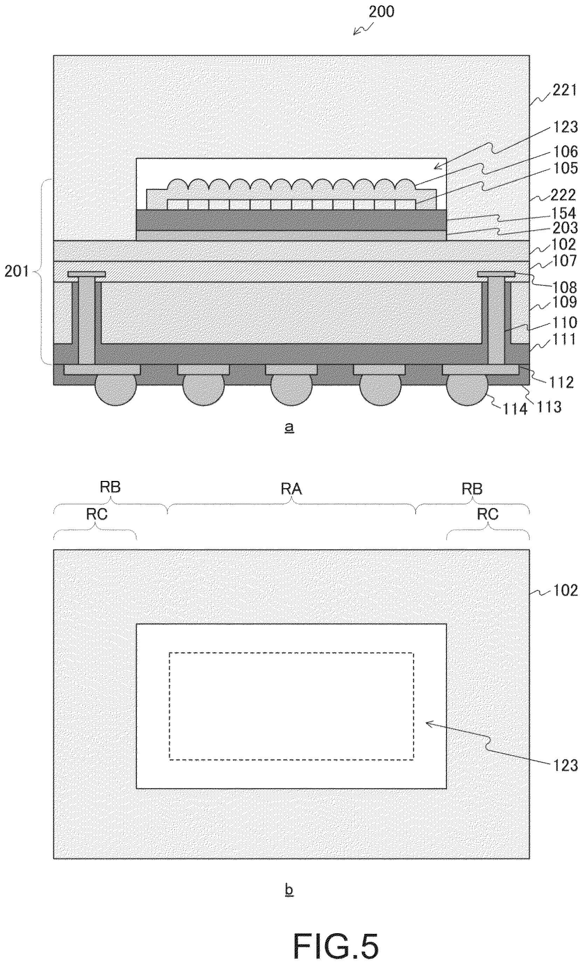

Fig. 5 is a diagram showing a configuration example of a solid-state imaging apparatus according to a third embodiment. Note that Part a of Fig. 5 a cross-sectional view showing a configuration example of a solid-state imaging apparatus 200, and Part b of Fig. 5 is a plan view showing a configuration example of the joint region RC of the semiconductor substrate 102.

In the solid-state imaging apparatus 200 shown in Fig. 5, a solid-state image sensor chip 201 and a transparent member 221 are provided instead of the solid-state image sensor chip 151 and the transparent member 171 in the above-mentioned second embodiment.

In the solid-state image sensor chip 201, an antireflection film 203 is provided instead of the anti-reflection film 103 in the above-mentioned second embodiment. The other configurations of the solid-state image sensor chip 201 are the same as the configurations of the solid-state image sensor chip 151 in the above-mentioned second embodiment. In the joint region RC of the peripheral portion of the imaging region RA, the anti-reflection film 203 is not disposed and the semiconductor substrate 102 is exposed from the antireflection film 203. The other configurations of the anti-reflection film 203 are the same as the configurations of the anti-reflection film 103 in the above-mentioned second embodiment. In the transparent member 221, a projecting portion 222 is provided instead of the projecting portion 172 of the above-mentioned second embodiment. The other configurations of the transparent member 221 are the same as the configurations of the transparent member 171 in the above-mentioned second embodiment.

The transparent member 221 is directly joined to the solid-state image sensor chip 201 via the projecting portion 222. At this time, the tip of the projecting portion 222 is directly joined to the semiconductor substrate 102 of the joint region RC.

As described above, in accordance with the above-mentioned third embodiment, the transparent member 221 is directly joined to the semiconductor substrate 102 exposed from the protective film 154 and the anti-reflection film 103. As a result, it is possible to directly join the solid-state image sensor chip 201 and the transparent member 221 to each other without interposing the protective film 154 and the anti-reflection film 203, and improve the reliability against thermal shock.

### <4. Fourth embodiment>

Although the transparent member 121 is directly joined to the protective film 104 of the solid-state image sensor chip 101 in the above-mentioned first embodiment, the transparent member 121 is directly joined to the protective film 104 via an inorganic film 252 provided in the transparent member 121 in this fourth embodiment.

This solid-state imaging apparatus according to the fourth embodiment is different from the solid-state imaging apparatus according to the first embodiment in that the inorganic film formed of a material different from that of the transparent member is interposed between the solid-state image sensor chip and the transparent member.

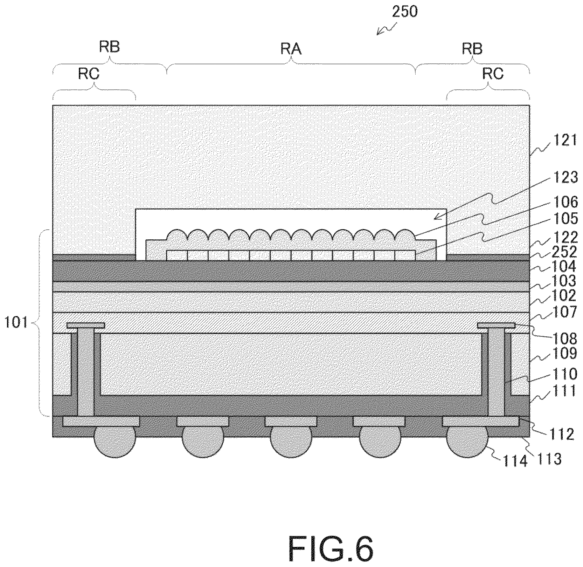

Fig. 6 is a cross-sectional view showing a configuration example of the solid-state imaging apparatus according to the fourth embodiment.

In a solid-state imaging apparatus 250 shown in Fig. 6, the inorganic film 252 is added to the configuration of the solid-state imaging apparatus 100 in the above-mentioned first embodiment. The other configurations of the solid-state imaging apparatus 250 shown in Fig. 6 are the same as the configurations of the solid-state imaging apparatus 100 in the above-mentioned first embodiment. The inorganic film 252 can be provided on the front surface of the projecting portion 122. The material of the inorganic film 252 is different from that material of the transparent member 121. The material of the inorganic film 252 is, for example, SiN, SiCN, or SiO₂. At this time, the material of the inorganic film 252 can be selected such that the joint strength, the difference in coefficient of thermal expansion, and the difference in refractive index between the solid-state image sensor chip 101 and the transparent member 121 are optimized. For example, in the case where the material of the transparent member 121 and the material of the protective film 104 are different from each other, the material of the inorganic film 252 can be the same as the material of the protective film 104. Specifically, in the case where the material of the transparent member 121 is glass and the material of the protective film 104 is SiN, the material of the inorganic film 252 can be SiN. The inorganic film 252 can be deposited on the front surface of the projecting portion 122 by a method such as CVD or sputtering.

Then, the projecting portion 122 of the transparent member 121 is directly joined to the joint region RC of the solid-state image sensor chip 101 via the inorganic film 252.

As described above, in accordance with the above-mentioned fourth embodiment, the inorganic film 252 is interposed between the solid-state image sensor chip 101 and the transparent member 121. As a result, even in the case where the material of the solid-state image sensor chip 101 and the material of the transparent member 121 are different from each other, it is possible to improve the joint strength between the solid-state image sensor chip 101 and the transparent member 121. Therefore, it is possible to improve the reliability of the solid-state imaging apparatus 250 while dealing with a decrease in joining area due to the miniaturization of the solid-state imaging apparatus 250. Further, by thinning the inorganic film 252, it is possible to reduce optical effects (such as reflection due to the difference in refractive index) while ensuring close contact.

### <5. Fifth embodiment>

Although the bottom surface of the recessed portion surrounded by the projecting portion 122 of the transparent member 121 has been flat in the above-mentioned first embodiment, a bottom surface 324 of the recessed portion surrounded by the projecting portion 122 of a transparent member 321 has a curvature in this fifth embodiment.

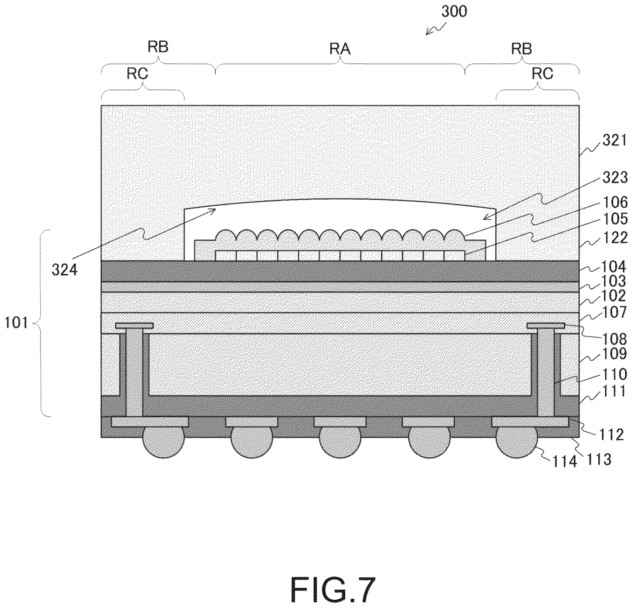

Fig. 7 is a cross-sectional view showing a configuration example of the solid-state imaging apparatus according to the fifth embodiment.

In a solid-state imaging apparatus 300 shown in Fig. 7, the transparent member 321 is provided instead of the transparent member 121 in the above-mentioned first embodiment. The other configurations of the solid-state imaging apparatus 300 are the same as the configurations of the solid-state imaging apparatus 100 in the above-mentioned first embodiment.

In the transparent member 321, a curvature is provided on the bottom surface 324 of the recessed portion surrounded by the projecting portion 122. At this time, a concave lens can be provided on the bottom surface 324 of the recessed portion surrounded by the projecting portion 122. A convex lens may be provided on the bottom surface 324 of the recessed portion surrounded by the projecting portion 122. The bottom surface 324 of the recessed portion surrounded by the projecting portion 122 may have a pattern having an optical function. The pattern having an optical function may be, for example, a digital lens, or a metalens. The other configurations of the transparent member 321 are the same as the configurations of the transparent member 121 in the above-mentioned first embodiment.

The transparent member 321 is directly joined to the solid-state image sensor chip 101 via the projecting portion 122. At this time, the transparent member 321 is directly joined to the peripheral portion of the imaging region RA via the projecting portion 122 such that a hollow portion 323 is formed on the imaging region RA.

As described above, in accordance with the above-mentioned fifth embodiment, a curvature is provided on the bottom surface 324 of the recessed portion surrounded by the projecting portion 122. As a result, it is possible to cause the transparent member 321 to have a light collection function and improve the optical performance without increasing the number of parts of the solid-state imaging apparatus 300.

### <6. Sixth embodiment>

Although anti-reflection films 381 and 382 are not formed on the surface of the transparent member 121 in the above-mentioned first embodiment, the anti-reflection films 381 and 382 are formed on the surface of a transparent member 371 in this sixth embodiment.

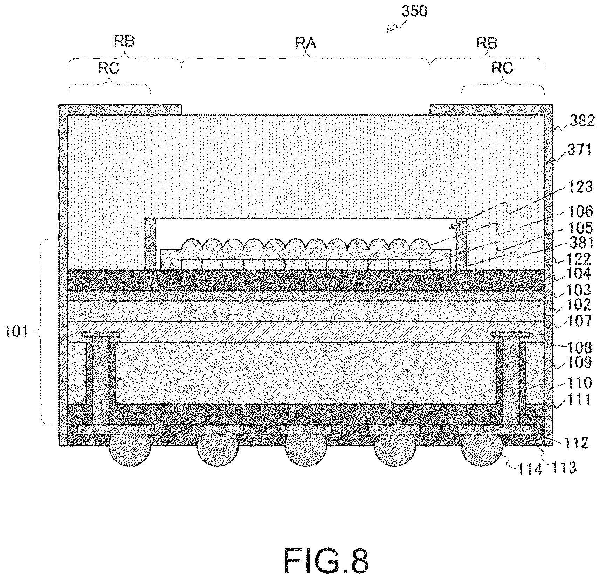

Fig. 8 is a cross-sectional view showing a configuration example of a solid-state imaging apparatus according to a sixth embodiment.

In a solid-state imaging apparatus 350 shown in Fig. 8, the transparent member 371 is provided instead of the transparent member 121 in the above-mentioned first embodiment. The other configurations of the solid-state imaging apparatus 350 shown in Fig. 8 are the same as the configurations of the solid-state imaging apparatus 100 in the above-mentioned first embodiment.

The transparent member 371 includes the anti-reflection films 381 and 382 formed on the surface of the transparent member 371 other than the light incident path to the imaging region RA of the solid-state image sensor chip 101. The anti-reflection film 381 can be provided on the inner side surface of the projecting portion 122. The anti-reflection film 382 can be provided on the outer side surface of the transparent member 371. Further, the anti-reflection film 382 may be provided on the upper surface of the transparent member 371 other than the light incident path to the imaging region RA. The materials of the anti-reflection films 381 and 382 may be the same as that of the anti-reflection film 103. The anti-reflection films 381 and 382 may have a multilayer structure. The anti-reflection film 382 may be extended on the side surface of the solid-state image sensor chip 101.

As described above, in accordance with the above-mentioned sixth embodiment, the anti-reflection films 381 and 382 are provided in the transparent member 371. As a result, it is possible to suppress stray light and a decrease in sensitivity due to reflection of light that has entered the transparent member 371. For this reason, it is possible to improve the optical performance without increasing the number of parts of the solid-state imaging apparatus 350.

Note that in the case where the anti-reflection film 382 is a light-absorbing film, the anti-reflection film 382 is disposed in a region other than the light incident path to the imaging region RA of the solid-state image sensor chip 101. However, in the case where the anti-reflection film 382 is a light-transmitting film, the antireflection film 382 may be disposed on the imaging region RA of the solid-state image sensor chip 101.

### <7. Seventh embodiment>

Although the side surface of the recessed portion surrounded by the projecting portion 122 of the transparent member 121 is flat in the above-mentioned first embodiment, a moth-eye structure is formed on the side surface of the recessed portion surrounded by a projecting portion 422 of a transparent member 421 in this seventh embodiment.

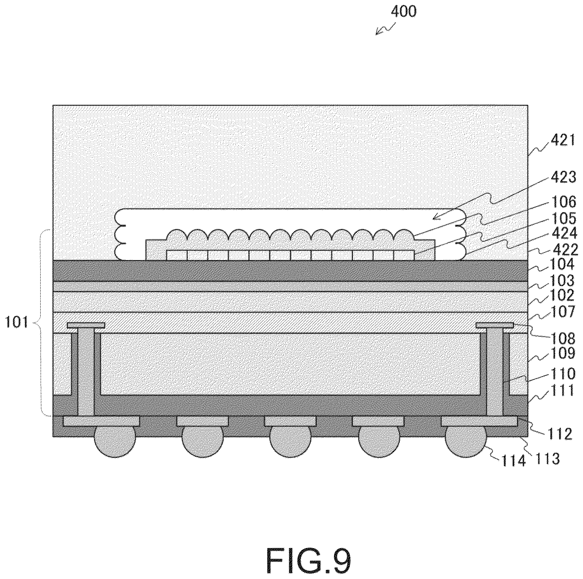

Fig. 9 is a cross-sectional view showing a configuration example of a solid-state imaging apparatus according to a seventh embodiment.

In a solid-state imaging apparatus 400 shown in Fig. 9, the transparent member 421 is provided instead of the transparent member 121 in the above-mentioned first embodiment. The other configurations of the solid-state imaging apparatus 400 shown in Fig. 9 are the same as the configurations of the solid-state imaging apparatus 100 in the above-mentioned first embodiment.

In the transparent member 421, the projecting portion 422 is provided instead of the projecting portion 122 in the above-mentioned first embodiment. The side surface of the recessed portion surrounded by the projecting portion 422 includes a structure 424 that scatters incident light. The structure 424 that scatters incident light may be, for example, a moth-eye structure. The other configurations of the transparent member 421 are the same as the configurations of the transparent member 121 in the above-mentioned first embodiment.

The transparent member 421 is directly joined to the solid-state image sensor chip 101 via the projecting portion 422. At this time, the transparent member 421 is directly joined to the peripheral portion of the imaging region RA via the projecting portion 422 such that a hollow portion 423 is formed on the imaging region RA.

As described above, in accordance with the above-mentioned seventh embodiment, the structure 424 that scatters incident light is provided on the side surface of the recessed portion surrounded by the projecting portion 422. As a result, it is possible to reduce flare due to stray light and improve the optical performance without increasing the number of parts of the solid-state imaging apparatus 400.

### <8. Eighth embodiment>

Although the side surface of the recessed portion surrounded by the projecting portion 122 of the transparent member 121 is flat in the above-mentioned first embodiment, a zigzag shape is formed on the side surface of the recessed portion surrounded by a projecting portion 472 of a transparent member 471 in this eighth embodiment.

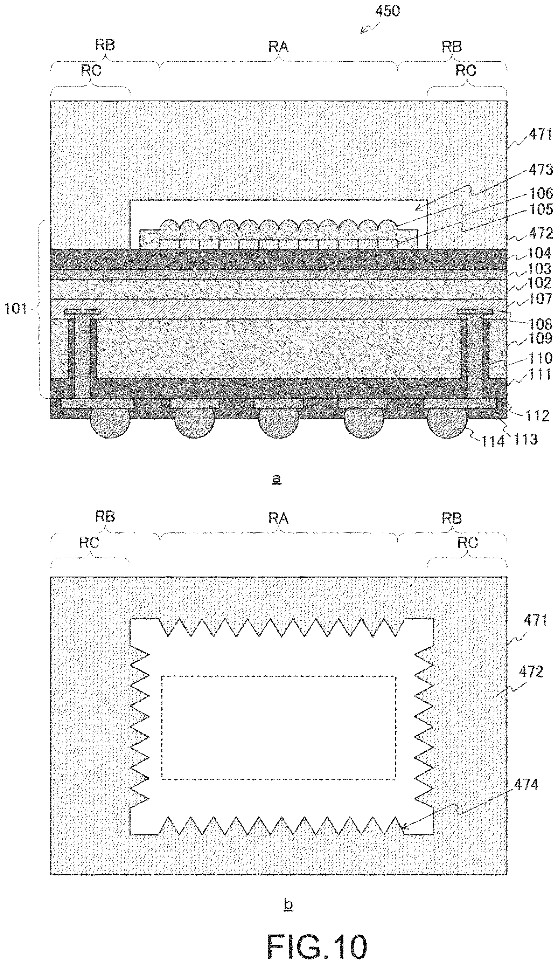

Fig. 10 is a diagram showing a configuration example of a solid-state imaging apparatus according to an eighth embodiment. Note that Part a of Fig. 10 is a cross-sectional view showing a configuration example of a solid-state imaging apparatus 450, and Part b of Fig. 10 is a plan view showing a configuration example of the transparent member 471.

In the solid-state imaging apparatus 450 shown in Fig. 10, the transparent member 471 is provided instead of the transparent member 121 in the above-mentioned first embodiment. The other configurations of the solid-state imaging apparatus 450 shown in Fig. 10 are the same as the configurations of the solid-state imaging apparatus 100 in the above-mentioned first embodiment.

The projecting portion 472 is provided in the transparent member 471 instead of the projecting portion 122 shown in Fig. 1. The side surface of the recessed portion surrounded by the projecting portion 472 includes a structure 474 that scatters incident light. The structure 474 that scatters incident light may have, for example, a zigzag shape in plan view. This zigzag shape may have a configuration in which two sides of an isosceles triangle or an equilateral triangle in plan view are arranged along the inner surface of the recessed portion surrounded by the projecting portion 472. The other configurations of the transparent member 471 are the same as the configurations of the transparent member 121 in the above-mentioned first embodiment.

The transparent member 471 is directly joined to the solid-state image sensor chip 101 via the projecting portion 472. At this time, the transparent member 471 is directly joined to the peripheral portion of the imaging region RA via the projecting portion 472 such that a hollow portion 473 is formed on the imaging region RA.

As described above, in accordance with the above-mentioned eighth embodiment, the structure 474 that scatters incident light is provided on the side surface of the recessed portion surrounded by the projecting portion 472. As a result, it is possible to reduce flare due to stray light and improve the optical performance without increasing the number of parts of the solid-state imaging apparatus 450.

### <9. Ninth embodiment>

Although the position of the tip of the projecting portion 122 of the transparent member 121 is aligned with the position of the end portion of the solid-state image sensor chip 101 in the above-mentioned first embodiment, the tip of a projecting portion 522 of a transparent member 521 is separated from the end portion of the solid-state image sensor chip 101 in this ninth embodiment. This solid-state imaging apparatus according to the ninth embodiment is different from the solid-state imaging apparatus according to the first embodiment in that a step that separates the tip of the projecting portion from the end portion of the solid-state image sensor chip is formed in the transparent member.

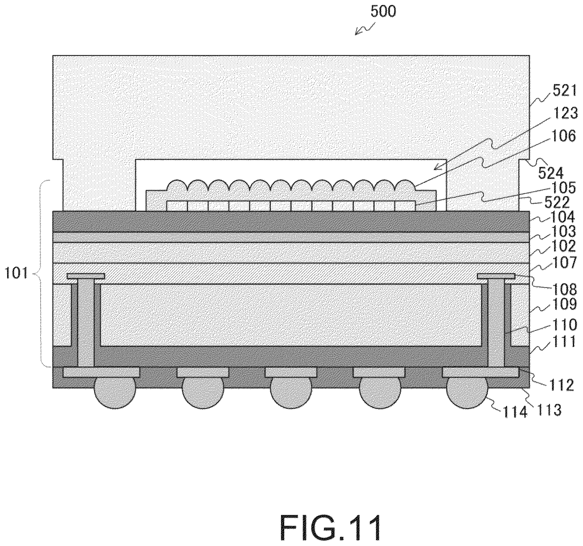

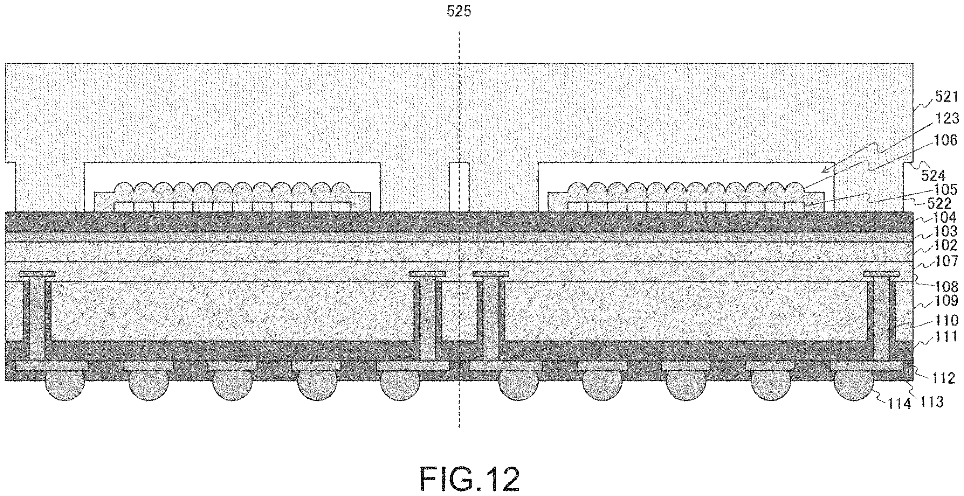

Fig. 11 is a diagram showing a configuration example of a solid-state imaging apparatus according to a ninth embodiment. Further, Fig. 12 is a diagram showing a configuration example of the solid-state imaging apparatus according to the ninth embodiment before being separated into pieces.

In a solid-state imaging apparatus 500 shown in Fig. 11, the transparent member 521 is provided instead of the transparent member 121 in the above-mentioned first embodiment. The other configurations of the solid-state imaging apparatus 500 shown in Fig. 11 are the same as the configurations of the solid-state imaging apparatus 100 in the above-mentioned first embodiment.

In the transparent member 521, the projecting portion 522 is provided instead of the projecting portion 122 shown in Fig. 1. The transparent member 521 includes a step 524 that separates the tip of the projecting portion 522 from the end portion of the solid-state image sensor chip 101. The step 524 is located on the outer side surface of the projecting portion 522. The height of the projecting portion 522 and the position of the step 524 in the height direction of the projecting portion 522 may be equal to or different from each other. The shape or the taper angle on the outside and inside of the projecting portion 522 may be equal to or different from each other. The other configurations of the transparent member 521 are the same as the configurations of the transparent member 121 in the above-mentioned first embodiment.

The transparent member 521 is directly joined to the solid-state image sensor chip 101 via the projecting portion 522. At this time, the transparent member 521 is directly joined to the peripheral portion of the imaging region RA while being spaced apart from both end portions of the solid-state image sensor chip 101 via the projecting portion 522. Here, as shown in Fig. 12, the solid-state image sensor chip 101 to which the transparent member 521 is joined is cut from the wafer by being cut at a cutting portion 525 by blade dicing.

As described above, in accordance with the above-mentioned ninth embodiment, by providing the step 524 that separates the tip of the projecting portion 522 from the end portion of the solid-state image sensor chip 101, no joint surface between the solid-state image sensor chip 101 and the transparent member 521 is formed in the cutting portion 525. Therefore, it is possible to suppress the occurrence of cracks and chipping near the joint surface between the solid-state image sensor chip 101 and the transparent member 521 when performing separation into pieces by blade dicing, and improve the yield.

### <10. Tenth embodiment>

Although grooves for stopping cracks 554 and 574 are not formed in the solid-state image sensor chip 101 and the transparent member 121, respectively, in the above-mentioned first embodiment, the groove for stopping cracks 554 and 574 are respectively formed in a solid-state image sensor chip 551 and a transparent member 571 in this tenth embodiment.

This solid-state imaging apparatus according to the tenth embodiment is different from the solid-state imaging apparatus according to the first embodiment in that the grooves for stopping cracks are formed in the solid-state image sensor chip and the transparent member.

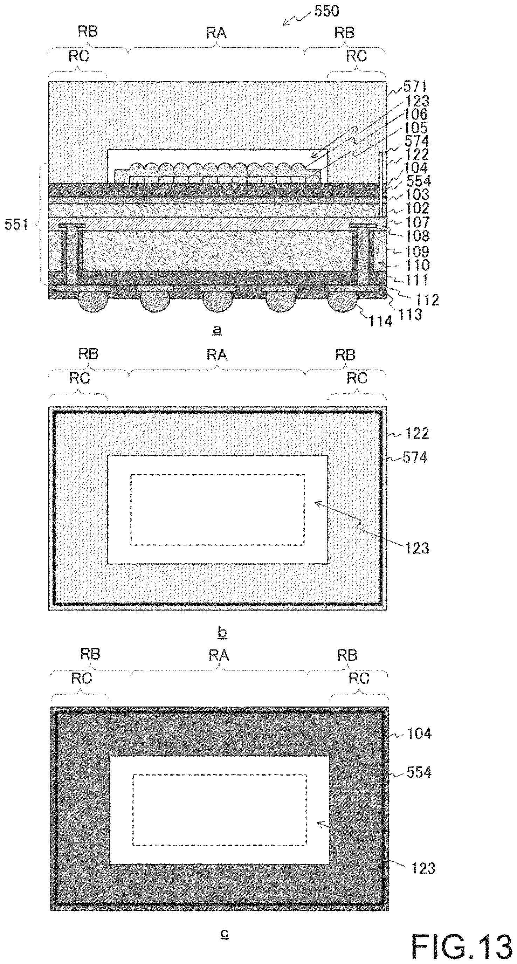

Fig. 13 is a diagram showing a configuration example of the solid-state imaging apparatus according to the tenth embodiment. Note that Part a of Fig. 13 is a cross-sectional view showing a configuration example of a solid-state imaging apparatus 550, Part b of Fig. 13 is a plan view showing a configuration example of the joint surface of the transparent member 571, and Part c of Fig. 13 is a plan view showing a configuration example of the joint surface of the solid-state image sensor chip 551.

In the solid-state imaging apparatus 550 shown in Fig. 13, the solid-state image sensor chip 551 and the transparent member 571 are provided instead of the solid-state image sensor chip 101 and the transparent member 121 in the above-mentioned first embodiment.

In the solid-state image sensor chip 551, a groove 554 is added to the solid-state image sensor chip 101 in the above-mentioned first embodiment. The groove 554 can be provided in the joint region RC of the solid-state image sensor chip 551 along the outer periphery of the solid-state image sensor chip 551. The groove 554 may be located in the protective film 104, penetrate the protective film 104 to reach the anti-reflection film 103, or penetrate the protective film 104 and the anti-reflection film 103 to reach the semiconductor substrate 102. The groove 554 does not necessarily need to be continuous and may be discontinuous. The groove 554 has a width within the range of 2 to 50 µm and a depth within the range of 10 to 100 µm and is favorably set within 100 µm from the end portion of the solid-state image sensor chip 551. The other configurations of the solid-state image sensor chip 551 are the same as the configurations of the solid-state image sensor chip 101 in the above-mentioned first embodiment.

In the transparent member 571, a groove 574 is added to the transparent member 121 in the above-mentioned first embodiment. The groove 574 can be provided in the joint region RC of the transparent member 571 along the outer periphery of the transparent member 571. The other configurations of the transparent member 571 are the same as the configurations of the transparent member 121 in the above-mentioned first embodiment.

As described above, in accordance with the above-mentioned tenth embodiment, the grooves 554 and 574 are respectively provided in the solid-state image sensor chip 551 and the transparent member 571. As a result, it is possible to stop, when performing separation into pieces by blade dicing, chipping and cracks that have occurred at the end portion of the solid-state image sensor chip 551 or the end portion of the transparent member 571 at the positions of the grooves 554 and 574 before reaching the imaging region RA, and improve the yield.

Note that although an example in which the grooves 554 and 574 are respectively provided in the solid-state image sensor chip 551 and the transparent member 571 has been shown in Fig. 13, a groove for stopping cracks may be provided in at least one of the solid-state image sensor chip 551 or the transparent member 571.

### <11. Eleventh embodiment>

Although a groove for exhausting released gas 602 is not formed in the solid-state image sensor chip 101 in the above-mentioned first embodiment, a linear groove 602 for discharging released gas is formed in a solid-state image sensor chip 601 in this eleventh embodiment.

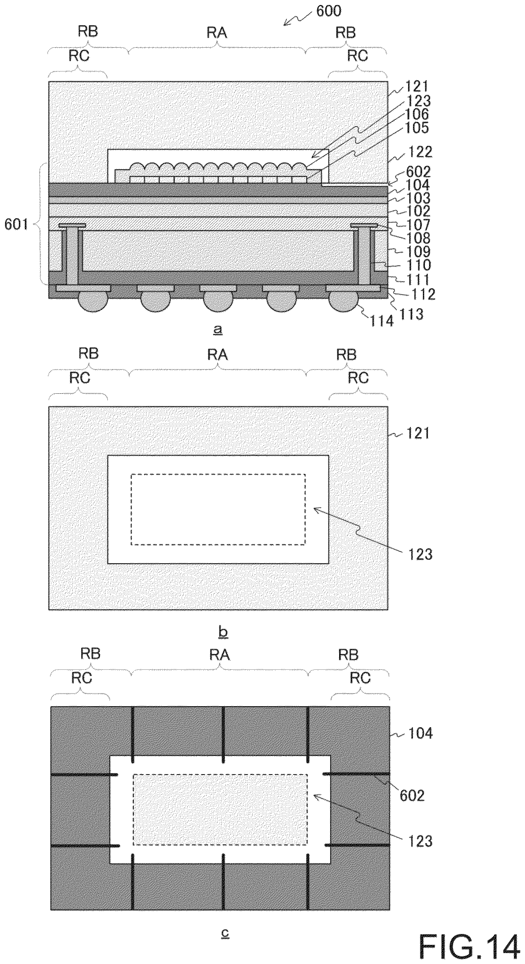

Fig. 14 is a diagram showing a configuration example of a solid-state imaging apparatus according to the eleventh embodiment. Note that Part a of Fig. 14 is a cross-sectional view showing a configuration example of a solid-state imaging apparatus 600, Part b of Fig. 14 is a plan view showing a configuration example of the joint surface of the transparent member 121, and Part c of Fig. 14 is a plan view showing a configuration example of the joint surface of the solid-state image sensor chip 601.

In the solid-state imaging apparatus 600 shown in Fig. 14, the solid-state image sensor chip 601 is provided instead of the solid-state image sensor chip 101 in the above-mentioned first embodiment. The other configurations of the solid-state imaging apparatus 600 shown in Fig. 14 are the same as the configurations of the solid-state imaging apparatus 100 in the above-mentioned first embodiment.

In the solid-state image sensor chip 601, the groove 602 is added to the solid-state image sensor chip 101 in the above-mentioned first embodiment. The groove 602 connects the hollow portion 123 to the outside of the transparent member 121. The groove 602 can be located in the protective film 104. The groove 602 may include a plurality of grooves or only one groove. The other configurations of the solid-state image sensor chip 601 are the same as the configurations of the solid-state image sensor chip 101 in the above-mentioned first embodiment.

As described above, in accordance with the above-mentioned eleventh embodiment, by providing the groove 602 in the solid-state image sensor chip 601, it is possible to cause the gas released from the solid-state image sensor chip 601 to escape to the outside via the groove 602. Therefore, it is possible to prevent damage to the solid-state image sensor chip 601 due to an increase in pressure within the hollow portion 123 and a decrease in optical characteristics due to attachment of the released gas to the transparent member 121.

Note that the groove 602 favorably has a width of less than 5 µm and a depth of less than 1 µm, and more favorably has a width of less than 1 µm and a depth of less than 10.4 m. As a result, it is possible to prevent moisture from entering the hollow portion 123 in a cleaning step or the like while allowing the released gas to escape via the groove 602, and improve the reliability of the solid-state imaging apparatus 600.

Note that although an example in which the groove 602 is provided in the solid-state image sensor chip 601 has been shown in Fig. 14, a groove for exhausting released gas may be provided in at least one of the solid-state image sensor chip 601 or the transparent member 121.

### <12. Twelfth embodiment>

Although a groove for exhausting released gas 652 is not formed in the solid-state image sensor chip 101 in the above-mentioned first embodiment, a zigzag groove 652 for discharging the released gas is formed in a solid-state image sensor chip 651 in this twelfth embodiment.

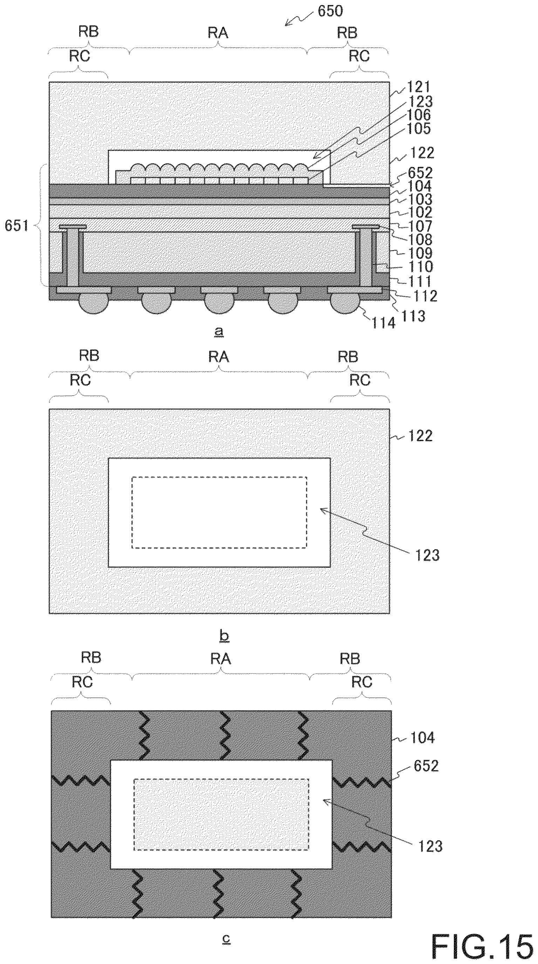

Fig. 15 is a diagram showing a configuration example of a solid-state imaging apparatus according to the twelfth embodiment. Note that Part a of Fig. 15 is a cross-sectional view showing a configuration example of a solid-state imaging apparatus 650, Part b of Fig. 15 is a plan view showing a configuration example of the joint surface of the transparent member 121, and Part c of Fig. 15 is a plan view showing a configuration example of the joint surface of the solid-state image sensor chip 651.

In the solid-state imaging apparatus 650 shown in Fig. 15, the solid-state image sensor chip 651 is provided instead of the solid-state image sensor chip 601 in the above-mentioned eleventh embodiment. The other configurations of the solid-state imaging apparatus 650 shown in Fig. 15 are the same as the configurations of the solid-state imaging apparatus 600 in the above-mentioned eleventh embodiment.

In the solid-state image sensor chip 651, the groove 652 is provided instead of the groove 602 in the above-mentioned eleventh embodiment. The groove 652 connects the hollow portion 123 to the outside of the transparent member 121. The shape of the groove 652 in plan view is not necessarily limited to a straight line, and may be a zigzag shape or a wavy shape. The groove 652 can be located in the protective film 104. The groove 652 may include a plurality of grooves or only one groove. The other configurations of the solid-state image sensor chip 651 are the same as the configurations of the solid-state image sensor chip 601 in the above-mentioned eleventh embodiment.

As described above, in accordance with the above-mentioned twelfth embodiment, by providing the groove 652 in the solid-state image sensor chip 651, it is possible to allow the gas released from the solid-state image sensor chip 651 to escape to the outside via the groove 652. Therefore, it is possible to prevent damage to the solid-state image sensor chip 651 due to an increase in pressure within the hollow portion 123 and a decrease in optical characteristics due to attachment of the released gas to the transparent member 121. Further, by making the groove 652 have a zigzag shape in plan view, it is possible to suppress moisture from entering the hollow portion 123 in a clearing step or the like while allowing the released gas to escape via the groove 652, and improve the reliability of the solid-state imaging apparatus 650.

Note that although an example in which the groove 652 is provided in the solid-state image sensor chip 651 has been shown in Fig. 15, a zigzag groove for exhausting released gas may be provided in at least one of the solid-state image sensor chip 651 or the transparent member 121.

### <13. Thirteenth embodiment>

Although a groove for stopping cracks554 and the groove for exhausting released gas 602 are not formed in the solid-state image sensor chip 101 in the above-mentioned first embodiment, the groove for stopping cracks554 and the groove for exhausting released gas 602 are formed in a solid-state image sensor chip 701 in this thirteenth embodiment.

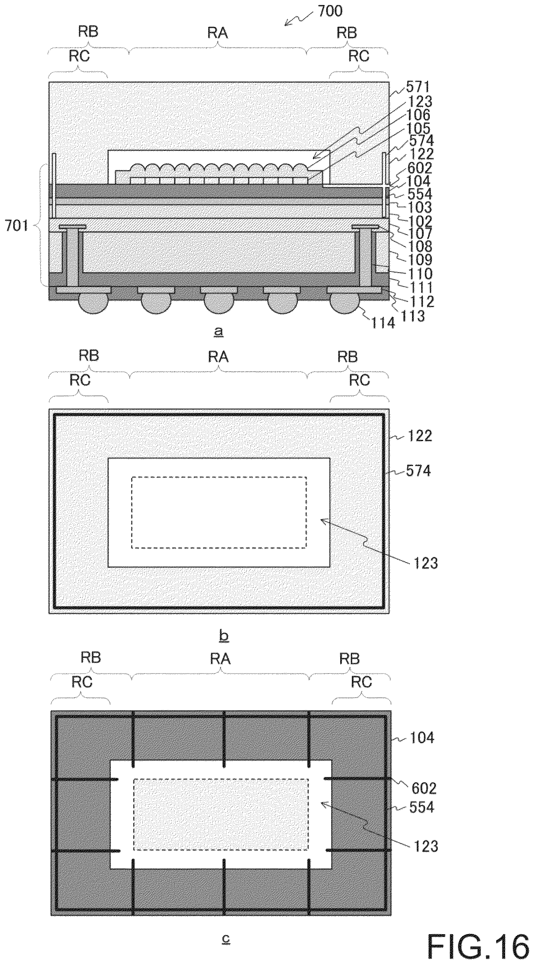

Fig. 16 is a diagram showing a configuration example of a solid-state imaging apparatus according to the thirteenth embodiment. Note that Part a of Fig. 16 is a cross-sectional view showing a configuration example of a solid-state imaging apparatus 700, Part b of Fig. 16 is a plan view showing a configuration example of the joint surface of the transparent member 571, and Part c of Fig. 16 is a plan view showing a configuration example of the joint surface of the solid-state image sensor chip 701.

In the solid-state imaging apparatus 700 shown in Fig. 16, the solid-state image sensor chip 701 is provided instead of the solid-state image sensor chip 551 in the above-mentioned tenth embodiment. The other configurations of the solid-state imaging apparatus 700 shown in Fig. 16 are the same as the configurations of the solid-state imaging apparatus 550 in the above-mentioned tenth embodiment.

In the solid-state image sensor chip 701, the groove 602 is added to the solid-state image sensor chip 551 in the above-mentioned tenth embodiment. The other configurations of the solid-state image sensor chip 701 are the same as the configurations of the solid-state image sensor chip 551 in the above-mentioned tenth embodiment.

As described above, in accordance with the above-mentioned thirteenth embodiment, the grooves 554 and 602 are provided in the solid-state image sensor chip 701, and the groove 574 is provided in the transparent member 571. As a result, it is possible to stop, when performing separation into pieces by blade dicing, chipping and cracks that have occurred at the end portion of the solid-state image sensor chip 701 or the end portion of the transparent member 571 at the positions of the grooves 554 and 574 before reaching the imaging region RA, and improve the yield. Further, it is possible to allow the gas released from the solid-state image sensor chip 701 to escape to the outside via the groove 602. Therefore, it is possible to prevent damage to the solid-state image sensor chip 701 due to an increase in pressure within the hollow portion 123 and a decrease in optical characteristics due to attachment of the released gas to the transparent member 571.

Note that although an example in which the grooves 554 and 602 are provided in the solid-state image sensor chip 601 has been shown in Fig. 16, a groove for stopping cracks and a groove for exhausting released gas may be provided in at least one of the solid-state image sensor chip 701 or the transparent member 571.

Further, the above-mentioned embodiments are examples for embodying the present technology, and the matters in the embodiments and the matters specifying the invention in the scope of claims have a corresponding relationship. Similarly, the matters specifying the invention in the scope of claims and the matters having the same names in the embodiments of the present technology have a corresponding relationship. However, the present technology is not limited to the embodiments and can be embodied by making various modifications thereto without departing from the essence of the present technology. Further, the effects described in the present specification are merely examples and are not limited, and other effects may be exhibited.

Note that the present technology may also take the following configurations.
(1) A solid-state imaging apparatus, including:
   a chip on which a solid-state image sensor is formed; and
   a transparent member that is directly joined to the chip via a projecting portion of the transparent member, the projecting portion maintaining a gap between the transparent member and an imaging region of the solid-state image sensor.
(2) The solid-state imaging apparatus according to (1) above, in which
   a joint between the chip and the transparent member has a single joint interface.
(3) The solid-state imaging apparatus according to (1) or (2) above, in which
   the transparent member is directly joined to a peripheral portion of the imaging region via the projecting portion such that a hollow portion is formed on the imaging region.
(4) The solid-state imaging apparatus according to any one of (1) to (3) above, in which
   the solid-state image sensor is a back-illuminated solid-state image sensor.
(5) The solid-state imaging apparatus according to any one of (1) to (3) above, in which
   the transparent member is a glass substrate on which the projecting portion is provided.
(6) The solid-state imaging apparatus according to (5) above, in which
   a coefficient of thermal expansion of glass of the glass substrate is within a range of 2.4 to 3.5 ppm/°C.
(7) The solid-state imaging apparatus according to any one of (1) to (6) above, in which
   the chip includes
   a back-surface wire formed on a surface opposite to a surface on which the imaging region is formed, and
   a through electrode that penetrates the chip and is connected to the back-surface wire.
(8) The solid-state imaging apparatus according to any one of (1) to (7) above, in which
   the chip includes
      a semiconductor substrate on which the imaging region is provided,
      an anti-reflection film formed on the semiconductor substrate,
      a protective film formed on the anti-reflection film,
      a color filter formed on the protective film of the imaging region, and
      an on-chip lens formed on the color filter of the imaging region, and
   the transparent member is directly joined to the protective film of a peripheral portion of the imaging region via the projecting portion.
(9) The solid-state imaging apparatus according to any one of (1) to (7) above, in which
   the chip includes
      a semiconductor substrate on which the imaging region is provided,
      an anti-reflection film formed on the semiconductor substrate,
      a protective film formed on the anti-reflection film of the imaging region,
      a color filter formed on the protective film of the imaging region, and
      an on-chip lens formed on the color filter of the imaging region, and
   the transparent member is directly joined to the anti-reflection film of a peripheral portion of the imaging region via the projecting portion.
(10) The solid-state imaging apparatus according to any one of (1) to (7) above, in which
   the chip includes
      a semiconductor substrate on which the imaging region is provided,
      an anti-reflection film formed on the semiconductor substrate of the imaging region,
      a protective film formed on the anti-reflection film of the imaging region,
      a color filter formed on the protective film of the imaging region, and
      an on-chip lens formed on the color filter of the imaging region, and
   the transparent member is directly joined to the semiconductor substrate of a peripheral portion of the imaging region via the projecting portion.
(11) The solid-state imaging apparatus according to any one of (1) to (10) above, further including
   an inorganic film that is provided on a surface of the projecting portion and is formed of a material different from that of the transparent member.
(12) The solid-state imaging apparatus according to (11) above, in which
   the material of the inorganic film is SiN, SiCN, or SiO₂.
(13) The solid-state imaging apparatus according to any one of (1) to (12) above, in which
   a bottom surface of a recessed portion surrounded by the projecting portion has a curvature or a pattern having an optical function.
(14) The solid-state imaging apparatus according to any one of (1) to (13) above, further including
   an anti-reflection film formed on a surface of the transparent member other than a light incident path to the imaging region.
(15) The solid-state imaging apparatus according to any one of (1) to (14) above, in which
   a side surface of a recessed portion surrounded by the projecting portion has a structure that scatters incident light.
(16) The solid-state imaging apparatus according to any one of (1) to (15) above, in which
   the transparent member includes a step that is located on an outer side surface of the projecting portion to separate a tip of the projecting portion from an end portion of the chip.
(17) The solid-state imaging apparatus according to any one of (1) to (16) above, further including
   at least one of a first groove provided along an outer periphery of the chip or a second groove that connects the hollow portion to an outside of the transparent member on at least one of a joint surface on a side of the projecting portion or a joint surface on a side of the chip.
(18) The solid-state imaging apparatus according to (17) above, in which
   the second groove has a width of less than 5 µm and a depth of less than 1 µm.
(19) A method of producing a solid-state imaging apparatus, including:
   a step of forming a projecting portion on a transparent member; and
   a step of directly joining the transparent member to a chip on which a solid-state image sensor is formed such that a gap between the transparent member and an imaging region of the solid-state image sensor is maintained via the projecting portion.
(20) The method of producing a solid-state imaging apparatus according to (19) above, in which
   the step of directly joining includes
   a step of activating at least one of a joint surface on a side of the chip or a joint surface on a side of the transparent member, and
   a step of crimping the joint surface on the side of the chip and the joint surface on the side of the transparent member at a temperature of 250°C or less.

### Reference Signs List

- 100: solid-state imaging apparatus
- 101: solid-state image sensor chip
- 102: semiconductor substrate
- 103: anti-reflection film
- 104: protective film
- 105: color filter
- 106: on-chip lens
- 107: wiring layer
- 108: land electrode
- 109: support substrate
- 110: through electrode
- 111: back-surface insulation film
- 112: back-surface wire
- 113: back-surface protective film
- 114: protruding electrode
- 121: transparent member
- 122: projecting portion
- 123: hollow portion

## Claims

1. A solid-state imaging apparatus, comprising:
a chip on which a solid-state image sensor is formed; and
a transparent member that is directly joined to the chip via a projecting portion of the transparent member, the projecting portion maintaining a gap between the transparent member and an imaging region of the solid-state image sensor.

2. The solid-state imaging apparatus according to claim 1, wherein
a joint between the chip and the transparent member has a single joint interface.

3. The solid-state imaging apparatus according to claim 1, wherein
the transparent member is directly joined to a peripheral portion of the imaging region via the projecting portion such that a hollow portion is formed on the imaging region.

4. The solid-state imaging apparatus according to claim 1, wherein
the solid-state image sensor is a back-illuminated solid-state image sensor.

5. The solid-state imaging apparatus according to claim 1, wherein
the transparent member is a glass substrate on which the projecting portion is provided.

6. The solid-state imaging apparatus according to claim 5, wherein
a coefficient of thermal expansion of glass of the glass substrate is within a range of 2.4 to 3.5 ppm/°C.

7. The solid-state imaging apparatus according to claim 1, wherein
the chip includes
a back-surface wire formed on a surface opposite to a surface on which the imaging region is formed, and
a through electrode that penetrates the chip and is connected to the back-surface wire.

8. The solid-state imaging apparatus according to claim 1, wherein
the chip includes
a semiconductor substrate on which the imaging region is provided,
an anti-reflection film formed on the semiconductor substrate,
a protective film formed on the anti-reflection film,
a color filter formed on the protective film of the imaging region, and
an on-chip lens formed on the color filter of the imaging region, and
the transparent member is directly joined to the protective film of a peripheral portion of the imaging region via the projecting portion.

9. The solid-state imaging apparatus according to claim 1, wherein
the chip includes
a semiconductor substrate on which the imaging region is provided,
an anti-reflection film formed on the semiconductor substrate,
a protective film formed on the anti-reflection film of the imaging region,
a color filter formed on the protective film of the imaging region, and
an on-chip lens formed on the color filter of the imaging region, and
the transparent member is directly joined to the anti-reflection film of a peripheral portion of the imaging region via the projecting portion.

10. The solid-state imaging apparatus according to claim 1, wherein
the chip includes
a semiconductor substrate on which the imaging region is provided,
an anti-reflection film formed on the semiconductor substrate of the imaging region,
a protective film formed on the anti-reflection film of the imaging region,
a color filter formed on the protective film of the imaging region, and
an on-chip lens formed on the color filter of the imaging region, and
the transparent member is directly joined to the semiconductor substrate of a peripheral portion of the imaging region via the projecting portion.

11. The solid-state imaging apparatus according to claim 1, further comprising
an inorganic film that is provided on a surface of the projecting portion and is formed of a material different from that of the transparent member.

12. The solid-state imaging apparatus according to claim 11, wherein
the material of the inorganic film is SiN, SiCN, or SiO₂.

13. The solid-state imaging apparatus according to claim 1, wherein
a bottom surface of a recessed portion surrounded by the projecting portion has a curvature or a pattern having an optical function.

14. The solid-state imaging apparatus according to claim 1, further comprising
an anti-reflection film formed on a surface of the transparent member other than a light incident path to the imaging region.

15. The solid-state imaging apparatus according to claim 1, wherein
a side surface of a recessed portion surrounded by the projecting portion has a structure that scatters incident light.

16. The solid-state imaging apparatus according to claim 1, wherein
the transparent member includes a step that is located on an outer side surface of the projecting portion to separate a tip of the projecting portion from an end portion of the chip.

17. The solid-state imaging apparatus according to claim 3, further comprising
at least one of a first groove provided along an outer periphery of the chip or a second groove that connects the hollow portion to an outside of the transparent member on at least one of a joint surface on a side of the projecting portion or a joint surface on a side of the chip.

18. The solid-state imaging apparatus according to claim 17, wherein
the second groove has a width of less than 5 µm and a depth of less than 1 µm.

19. A method of producing a solid-state imaging apparatus, comprising:
a step of forming a projecting portion on a transparent member; and
a step of directly joining the transparent member to a chip on which a solid-state image sensor is formed such that a gap between the transparent member and an imaging region of the solid-state image sensor is maintained via the projecting portion.

20. The method of producing a solid-state imaging apparatus according to claim 19, wherein
the step of directly joining includes
a step of activating at least one of a joint surface on a side of the chip or a joint surface on a side of the transparent member, and
a step of crimping the joint surface on the side of the chip and the joint surface on the side of the transparent member at a temperature of 250°C or less.
